(19) Europäisches Patentamt
European Patent Office
Office européen des brevets

(11) Publication number: **0 186 798 B1**

# (12) EUROPEAN PATENT SPECIFICATION

(45) Date of publication of patent specification: **26.02.92** (51) Int. Cl.[5]: **G03F 7/40**

(21) Application number: **85115321.3**

(22) Date of filing: **03.12.85**

## (54) Top imaged plasma developable resists.

(30) Priority: **07.12.84 US 679527**

(43) Date of publication of application:
**09.07.86 Bulletin 86/28**

(45) Publication of the grant of the patent:
**26.02.92 Bulletin 92/09**

(84) Designated Contracting States:
**DE FR GB IT**

(56) References cited:
**EP-A- 0 017 032**
**EP-A- 0 136 130**
**EP-A- 0 161 476**
**EP-A- 0 184 567**
**US-A- 4 430 153**

**JOURNAL OF THE ELECTROCHEMICAL SOCIETY, vol. 131, no. 7, July 1984, pages 1664-1670, Manchester, New Hampshire, US; T.M. WOLF et al.: "The scope and mechanism of new positive tone Gas-phase-functionalized plasma-developed resists"**

(73) Proprietor: **International Business Machines Corporation**
**Old Orchard Road**
**Armonk, N.Y. 10504(US)**

(72) Inventor: **Chiong, Kaolin**
**46 Heritage Drive**
**Pleasantville, N.Y. 10570(US)**
Inventor: **Chow, Ming-Fea**
**Beyer Drive**
**Poughquag, N.Y. 12570(US)**
Inventor: **Yang, Jer-Ming**
**2570 Barry Court**
**Yorktown Heights, N.Y. 10598(US)**

(74) Representative: **Kreidler, Eva-Maria, Dr. rer. nat.**
**Schönaicher Strasse 220**
**W-7030 Böblingen(DE)**

**EP 0 186 798 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

SOLID STATE TECHNOLOGY, vol. 27, no. 2, February 1984, pages 145-155, Port Washington, New York, US; G.N. TAYLOR et al.: "The role of inorganic materials in dry-processed resist technology"

PATENT ABSTRACTS OF JAPAN, vol. 6, no. 262 (P-164)[1140], 21st December 1982; & JP-A-57 157 241 (OKI DENKI KOGYO K.K.) 28-09-1982

PATENT ABSTRACTS OF JAPAN, vol. 8, no. 167 (E-258)[1604], 2nd August 1984; & JP-A-59 61 928 (HITACHI SEISAKUSHO K.K.) 09-04-1984

## Description

The present invention is concerned with a method of converting the upper portion of a layer of polymeric material into a dry-etch resistant form. The method can be used to produce multi-layer, plasma-developable resists which are capable of providing submicron resolution.

Many of the recent advancements in electronic components have resulted from improvements in manufacturing techniques, and particularly from microlithography improvements. However, often such improvements have been achieved by increasing the complexity of the microlithographic process, e.g. the number of resist layers utilized to obtain a particular functional configuration in the finished electronic component. The additional process steps required to provide the additional resist layers significantly increase the overall cost of production for a given functional configuration. There is a continuing search for methods of simplifiying the microlithography utilized to produce a given electronic component.

Another current trend in microlithography is the use of dry etching techniques to develop the resist image. This is because conventional wet processes which utilize solvent development do not provide the anisotropic development considered necessary to achieve optimal dimensional control within the parameters of today's systems. Examples of dry-developable resists are provided in U.S. Patents 4,426,247, 4,433,044, 4,357,369 and 4,430,153. All of these patents make use of silicon to create an oxygen plasma-developable resist. In some cases the silicon is present as a part of the resist polymer initially; in other cases, after the resist polymer is applied to a substrate, it is reacted with a silicon-containing reagent to make it oxygen plasma-developable. A recent example of the latter type of plasma-developable resist is described in European Patent Application 85 104 228.3. However, none of these processes are directed at producing a multilayer resist via top imaging of a single layer of resist material.

EP-A-0 184 567, relates to a process for forming a negative tone image with photoresist layers consisting of a photosensitive compound mixed with or attached to a polymer compound. According to all examples and claims 2 and 3 the photosensitive compound is a diazoquinone, preferably a diazo-dihydro-oxo-1-naphthalene or benzene sulfonic acid. The polymeric compound is a phenolic resin. Therefore, this prior art reference cannot be regarded as relevant prior art reference with respect to the individual compounds (1) to (3) of claim 1 of the present invention.

J. Electrochem. Soc., Vol. 131, No. 7, July 1984, pp. 1658-64 relates to the difference in functionalization of the unirradiated and the irradiated areas occurring when an exposed resist such as Selectilux N-60 is treated with gaseous inorganic halides. Selectilux N-60 is a negative- acting photoresist consisting of a bis-azide sensitizer in a partially cyclized poly(isoprene) host. In this publication there is only mentioned (p. 1668) that the above specified photoresist layer was treated upon deep UV exposure with $SiCl_4$, and that positive tone patterns were obtained upon oxygen reactive ion etching, thus confirming "azide" complexation. There is no appreciation that the upper portion of a layer of polymeric material comprising the compounds of claim 1 of the present invention can be converted into a dry etch resistant form by reaction and bonding of an organometallic material to reactive sites in the irradiated areas of said layer of polymeric material.

Solid State Technology, Vol. 27, No. 2, Feb. 1984, pp. 145-55 relates to a gas phase functionalization process of a resist with groups A or of the same resist with product groups P upon UV-irradiation. Gas phase functionalization of either A or P by inorganic reagent results in positive or negative tone pattern. Again this process bears no relation to the process of the present invention and the compounds used therein.

The object of the present invention is a process which reduces the number of resist layer applications required to obtain high resolution submicron electronic component features while simultaneously providing for dry development. Such a process is particularly useful in the manufacture of electronic components.

The object of the invention is achieved by a process according to claim 1. In accordance with the present invention, a method is provided for converting the upper portion of a layer of polymeric material into a dry etch-resistant form. Oxygen plasma can then be used to develop the entire resist structure. The lithographic process can utilize either high-absorptivity radiation-sensitive polymers which can be top imaged upon exposure to a radiation source or more transparent radition-sensitive polymers and carefully controlled conditions in subsequent process steps. For purposes of this specification and the claims, "radiation" should be interpreted to include both photon (ultraviolet light from 150 nm - 600 nm and radiation emission sources such as electron beam, ion beam, and X-ray.

In the most preferred embodiment of the present invention, a layer of high-absorptivity polymeric material is exposed to radiation which creates reactive hydrogens within the upper portion of the layer by moleculare rearrangement within the irradiated area. The reactive hydrogens are subsequently reacted with an organometallic reagent to form an etch barrier within the upper portion of the layer. In the case of a

polymeric resist which is to be imaged pattern-wise, the layer of polymeric resist is exposed to patterned radiation which creates the labile and reactive hydrogens within the upper portion of the layer in the pattern-wise irradiated areas. Irradiation is followed by treatment with an organometallic reagent to create the etch-resistant upper portion of the layer in the pattern-wise irradiated areas. Subsequent development of the resist image using dry development methods such as oxygen plasma produces at least a two-layer resist pattern with high aspect ratio and straight walls or under cut profiles, depending on etch conditions utilized. A resist pattern with more than two layers can be obtained by applying the polymeric resist to be imaged over other layers of polymeric resist material. The other layers of polymeric resist material need not be sensitive to radiation.

One preferred embodiment of the present invention wherein a pattern-wise imaged two-layer resist is formed comprises:

(a) providing a layer of polymeric material comprised of a radiation-sensitive component selected from the group consisting of (1) o-nitrobenzyl derivatives, which rearrange on exposure to radiation to form alcohols, acids, and amines, (2) photo-Fries reactive units, and (3) mixtures thereof;

(b) pattern-wise irradiating surface portions of the layer of polymeric material to include molecular rearrangement of the radiation-sensitive component within the upper portion of the layer, to form reaction products having labile and reactive hydrogens in the upper portions of the irradiated areas; and

(c) treating the reaction products of the irradiated layer with an organometallic reagent to react and bond the organometallic reagent at the reactive hydrogen sites.

An additional step can be used to dry develop the two layer resist, comprising:

(d) developing the patterned image by treatment with an oxygen plasma.

A less preferred embodiment utilizes a more transparent, radiation-sensitive polymer, wherein irradiation may penetrate up to the entire layer thickness. In order to convert this irradiated layer into two layers, process conditions must be carefully controlled during the reaction with the organometallic reagent. The penetration of the organometallic reagent must be limited to the portion of the layer which is to become etch resistant.

Embodiments of the present invention provide that the layer of polymeric material ranges from about 0.5 micrometer to about 20 micrometers in thickness, and that the upper portion of the layer which undergoes reaction with the organometallic reagent ranges from about 0.1 to 1.0 micrometer in depth.

Preferred embodiments of the present invention provide that the layer of polymeric material ranges from about 1 to about 3 microns in thickness, and that the upper portion which undergoes reaction with the organometallic reagent ranges from about 0.1 to about 0.5 micrometers in depth.

The polymeric material of the preferred embodiments comprises at least one compound selected from the group consisting of:

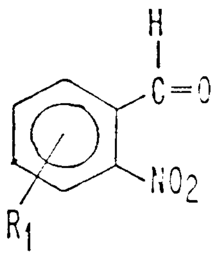 , 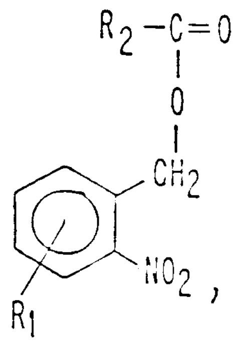 , 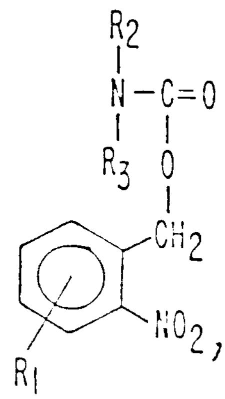 ,

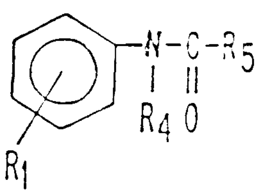 , 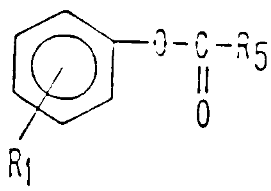 and 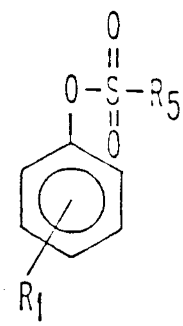

wherein $R_1$, $R_2$, $R_3$ and $R_5$ = H, alkyl, aryl or part of a polymer backbone, and $R_4$ = H, $C_nH_{2n+1}$ wherein n ranges from 1 to about 5, phenyl or substituted phenyls.

The method of the present invention reduces the number of resist layer applications required to obtain high resolution submicron electronic component features while simultaneously providing for dry development of the resist image.

The above and many other features and attendant advantages of the invention will become apparent as the invention becomes better understood by reference to the following accompanying drawings and detailed description.

- Fig. 1 is a diagramatic cross-sectional view of a substrate with a layer of polymeric material applied to the upper surface.
- Fig. 2 shows the same cross-sectional view wherein the upper surface of the layer of polymeric material is patternwise irradiated so that molecular rearrangement occurs in the upper portion of the irradiated layer.
- Fig. 3 shows the cross-sectional view after reaction of the reactive hydrogens created during the molecular rearrangement with an organometallic reagent.
- Fig. 4 shows the two-layer structure created upon the surface of the substrate upon dry development of the imaged polymeric layer.

The polymeric material used to create the top-imaged two-layer resist may be comprised of a number of different materials, so long as labile and reactive hydrogens are created upon irradiation. Polymeric resist materials which meet this requirement include o-nitrobenzene derivatives, polymers capable of photo-Fries rearrangement, and mixtures thereof. Upon irradiation, acids, alcohols, and amines with reactive hydrogens are generated. Examples of such materials are:

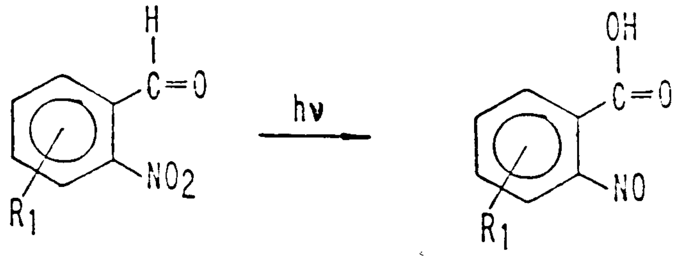

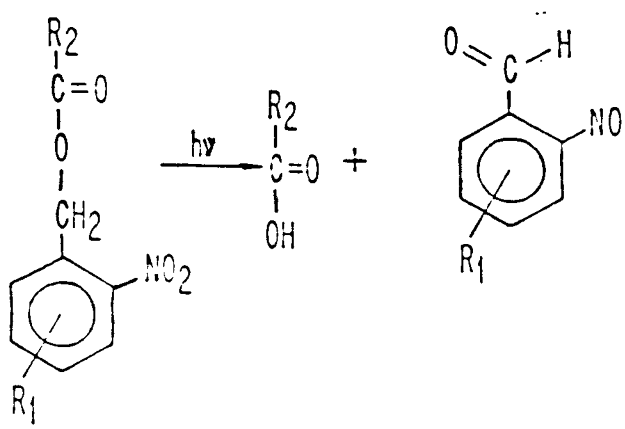

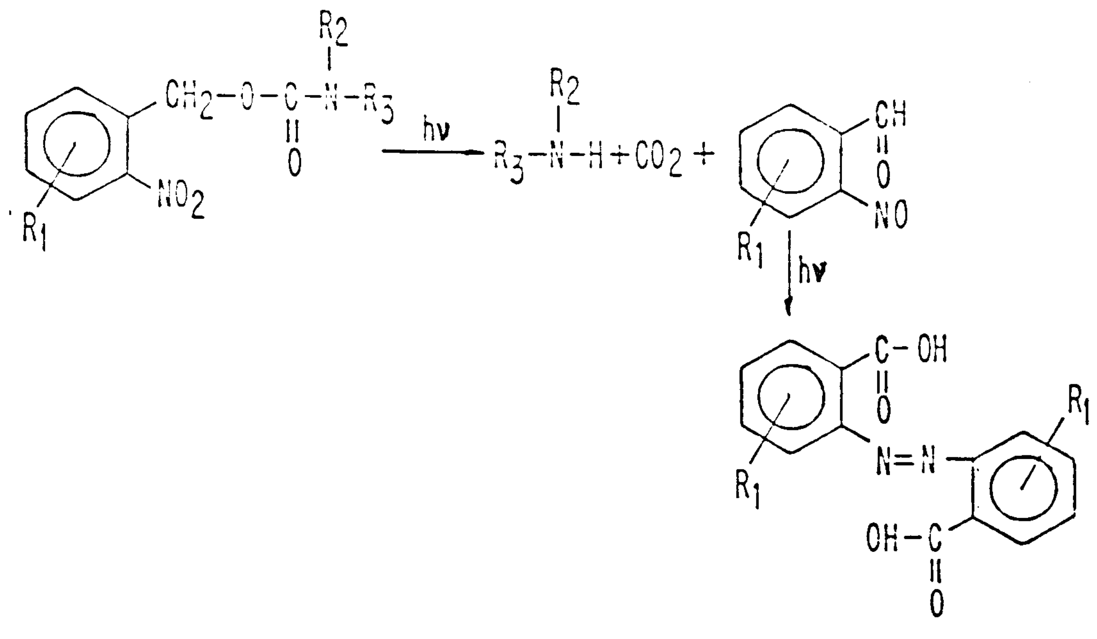

wherein $R_1$, $R_2$, $R_3$, and $R_5$ = H, alkyl, aryl, or part of a polymer backbone and $R_4$ = H, $C_nH_{2n+1}$ wherein n ranges from 1 to about 5, phenyl or substituted phenyls.

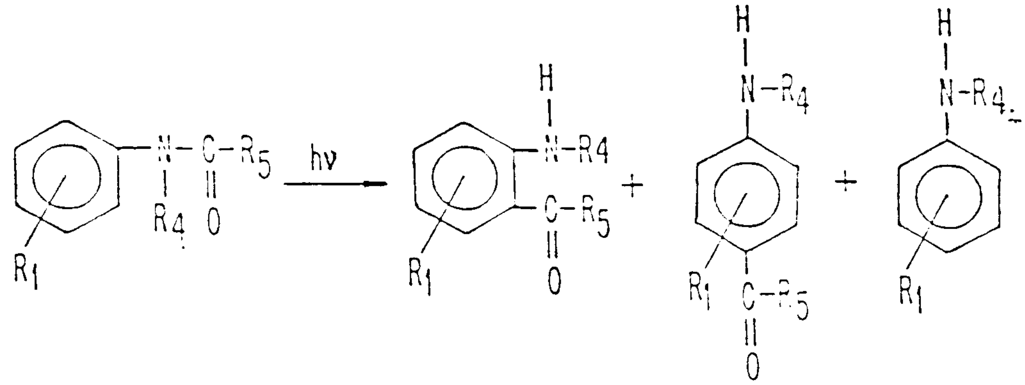

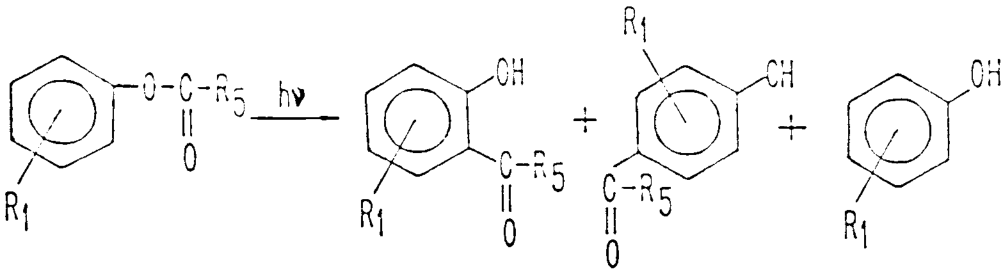

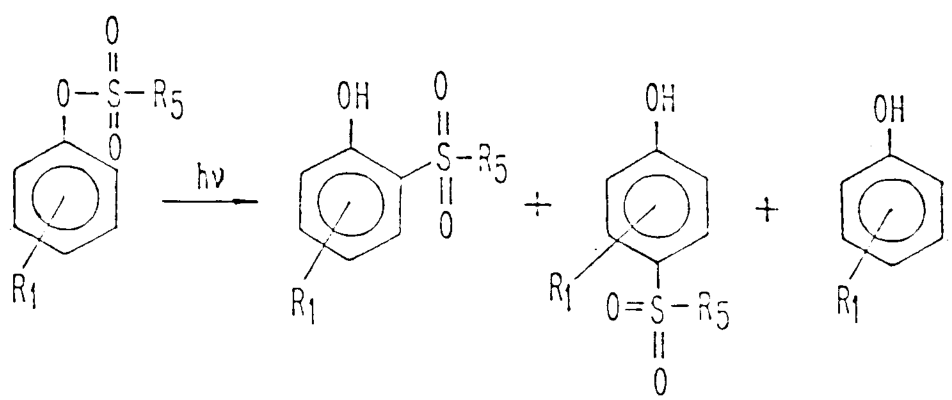

wherein $R_1$, $R_2$, $R_3$, and $R_5$ = H, alkyl, aryl, or part of a polymer backbone, and $R_4$ = H, $C_nH_{2n+1}$ where n ranges from 1 to about 5, phenyl or substituted phenyls.

Materials of this type can be used alone or in combination with compatible polymeric materials. Compounds such as substituted o-nitrobenzaldehyde and esterified phenols can be mixed together with polymers which have no labile or reactive hydrogens, e.g., PMMA (poly methyl methacrylate), rubbers, PMIPK (poly methylisopropenyl ketone), and polystyrene and its derivatives. Upon irradiation, the molecules which are sensitive to the radiation undergo rearrangement in the penetrated portion of the irradiated area of the polymeric layer, to yield products with labile and reactive hydrogens. The labile and reactive hydrogens can be subsequently reacted with an organometallic reagent to create the top-imaged resist.

EXAMPLE I

Acetylated polyvinylphenol of the structure

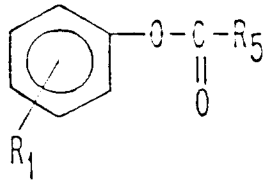

wherein $R_1$ = polymer backbone structure and $R_2$ = $CH_3$. was dissolved in diglyme at a concentration of about 30 % by weight acetylated polyvinylphenol. The solution was applied to a silicon oxide substrate using standard spin coating techniques. After application of the solution coating, the coated substrate was dried at about 80 °C on a hotplate, to remove the diglyme solvent. Fig. 1 is a cross-sectional view of the polymeric resist material (acetylated polyvinylphenol) layer 12 atop the silicon oxide substrate 10. The thickness of the dried acetylated polyvinylphenol layer 12 was about 0.7 micrometers.

The coated substrate was then exposed to patterned deep UV radiation at a dosages ranging from about 100 to about 800 mj/cm$^2$. Fig. 2 shows the same cross-sectional view after irradiation, wherein the irradiated areas 14 have experienced molecular rearrangement during which labile and reactive hydrogen sites have been created. Subsequently, the irradiated polymeric layer was exposed to HMDS (hexamethyldisilazane) vapor in order to silylate the active hydrogens created during the irradiation. Fig. 3 shows the cross-sectional view after treatment of the irradiated polymeric resist material with HMDS, so that a sylicated dry-etch-resistant form of material 16 was created in the upper portion of the irradiated areas. A good silylated image 16 formed within approximately 40 to 50 minutes after application of the HMDS reagent to the irradiated areas.

The silylation reaction was followed by treatment of the structure described above with oxygen plasma at about 1.33 mbar and 0.3 Watts/cm$^2$ for a period of about 6 minutes. The resultant two layer resist structure 18 was comprised of a silylated upper layer approximately 0.3 micrometers thick and a lower layer of acetylated polyvinylphenol about 0.4 micrometers thick, as depicted in Fig. 4. Note that treatment of an equivalent layer of unreacted polyvinylphenol with oxygen plasma under the same conditions results in ashing of the layer within about 4 to 5 minutes.

The two-layer resist formed using the above process exhibited line widths of about one micrometer wherein the line sidewalls showed negligible undercutting upon oxygen plasma development.

**Claims**

**1.** Method of converting the upper portion (16) of a layer of polymeric material (12) into a dry etch resistant form, comprising:

(a) applying a layer (12) of polymeric material to said substrate (10), wherein said polymeric material is comprised of at least one component which undergoes molecular rearrangement on irradiation to produce labile and reactive hydrogens and is selected from the group consisting of (1) o-nitrobenzyl derivatives which rearrange on exposure to radiation to form alcohols, acids, and amines, (2) photo-Fries reactive units, and (3) mixtures thereof;

(b) pattern-wise irradiating surface portions (14) of said layer of polymeric material to induce molecular rearrangement of said component and the formation of labile and reactive hydrogens within at least the upper portion (16) of said pattern-wise irradiated areas; and

(c) treating said reaction products of said irradiated layer with a reactive organometallic reagent to react and bond said organometallic reagent at said reactive sites in the upper portion (16) of said layer of polymeric material whereby said upper portion is dry etch resistant.

**2.** Method of Claim 2 wherein said component of said polymeric material is selected from the group consisting of

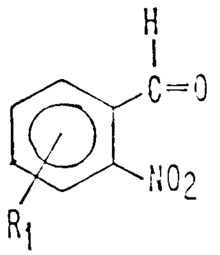,

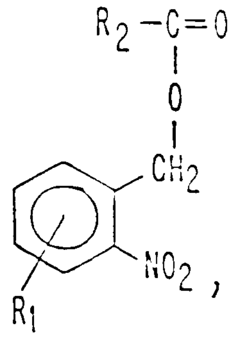,

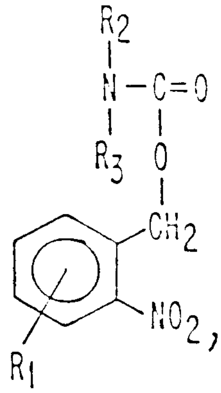,

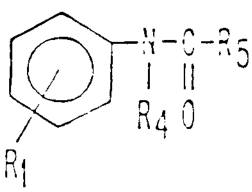,

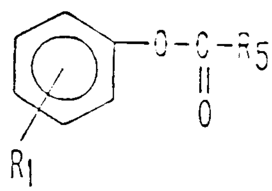

and

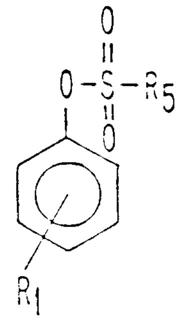

wherein $R_1$, $R_2$, $R_3$ and $R_5$ = H, alkyl, aryl, or part of a polymer backbone, and $R_4$ = H, $C_nH_{2n+1}$ wherein n ranges from about 1 to about 5, phenyl or substituted phenyls.

**3.** Method of Claim 2 wherein $R_1$ forms part of a polymer backbone is a styrene derivative or an acrylate based polymer, $R_2$, $R_3$, $R_5$, = H, $C_nH_{2n+1}$ wherein n ranges from 1 to about 15, phenyl, substituted phenyls, and other radicals which are benzene derivatives, and $R_4$ = H, $C_nH_{2n+1}$ wherein n ranges from 1 to about 5, phenyl, and substituted phenyls.

**4.** Method of Claim 1 wherein said irradiation source is selected from the group consisting of photon emission sources, electron beam, ion beam, and X-ray.

**5.** Method of Claim 1 including the additional step of:

(d) developing the patterned image in said irradiated (14) and reacted areas (16) by treatment with an oxygen plasma.

**6.** Method of Claim 1 wherein said layer of polymeric material (12) ranges from about 0.5 to about 20 micrometers in thickness.

**7.** Method of Claim 6 wherein said layer of polymeric material ranges from about 1.0 to about 3.0 micrometers in thickness.

**8.** Method of Claim 1 wherein said irradiated upper portion of said pattern-wise irradiated areas of said layer of polymeric material ranges from about 0.1 to about 1.0 micrometers in depth.

**9.** Method of Claim 8 wherein said irradiated upper portion of said pattern-wise irradiated areas of said layer of polymeric material ranges from about 0.1 to about 0.5 micrometers in depth.

**10.** Method of Claim 8 wherein said molecular rearrangement of said at least one component extends primarily within said upper portion of said layer of polymeric material.

**11.** Method of Claim 8 wherein said reactive organometallic reagent is comprised of a silicon-containing

compound.

**12.** Method of Claim 1 wherein said substrate (10) comprises a polymeric material which is either radiation or non-radiation sensitive.

**13.** Method of Claim 1 wherein said substrate (10) comprises an inorganic material.

**Revendications**

**1.** Procédé pour convertir la partie supérieure (16) d'une couche de matériau polymère (12) en une forme qui résiste à l'attaque à sec, comprenant:

(a) l'application d'une couche (12) de matériau polymère sur un substrat (10), ce matériau polymère étant composé d'au moins un composant qui subit un réarrangement moléculaire sous l'effet d'une irradiation pour produire des atomes d'hydrogène labiles et réactifs et étant choisi dans le groupe consistant en (1) des dérivés o-nitrobenzyliques qui se réarrangent sous l'effet d'une exposition à une radiation pour former des alcools, des acides et des amines, (2) des unités réactives photo-Fries et (3) leurs mélanges;

(b) l'irradiation selon un motif des parties superficielles (14) de cette couche de matériau polymère pour induire un réarrangement moléculaire de ce composant et la formation d'atomes d'hydrogène labiles et réactifs à l'intérieur d'au moins la partie supérieure (16) de ces zones irradiées selon un motif; et

(c) le traitement de ces produits réactionnels de cette couche irradiée avec un réactif organométallique réactif pour faire réagir et fixer ce réactif organométallique aux sites réactifs dans la partie supérieure (16) de cette couche de matériau polymère, de telle sorte que cette partie supérieure est résistante à une attaque à sec.

**2.** Procédé suivant la revendication 1, dans lequel ce composant de ce matériau polymère est choisi dans le groupe comprenant:

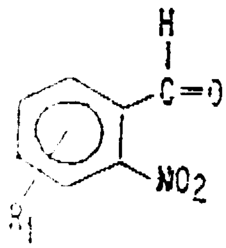 , 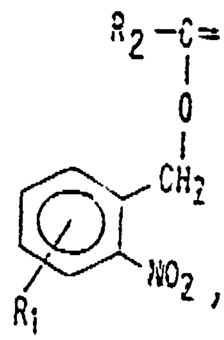 , 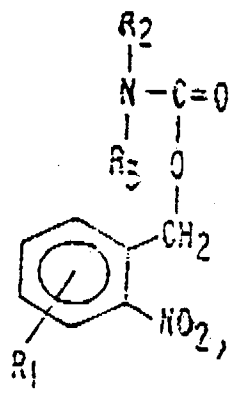 ,

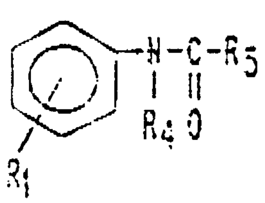 , 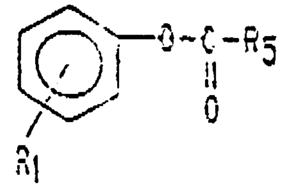 et 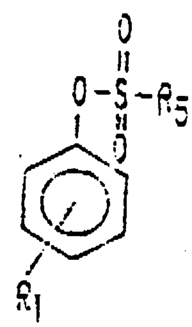

où $R_1$, $R_2$, $R_3$ et $R_5$ sont un atome d'hydrogène, un groupe alkyle, aryle ou une partie d'un squelette de polymère, et $R_4$ est un atome d'hydrogène ou un groupe $C_nH_{2n+1}$ dans lequel n est de l'ordre

d'environ 1 à 5, un groupe phényle ou phényle substitué.

3. Procédé suivant la revendication 2, dans lequel $R_1$ forme une partie d'un squelette de polymère qui est un dérivé du styrène ou un polymère acrylique, $R_2$, $R_3$ et $R_5$ sont un atome d'hydrogène, un groupe $C_nH_{2n+1}$ dans lequel n est de l'ordre d'environ 1 à 15, un groupe phényle ou phényle substitué et d'autres radicaux qui sont des dérivés benzéniques, et $R_4$ est un atome d'hydrogène ou un groupe $C_nH_{2n+1}$ dans lequel n est de l'ordre d'environ 1 à 5, un groupe phényle ou phényle substitué.

4. Procédé suivant la revendication 1, dans lequel la source d'irradiation est choisie dans le groupe comprenant des sources émettant des photons, un faisceau électronique, un faisceau ionique et des rayons X.

5. Procédé suivant la revendication 1, comprenant l'étape supplémentaire de :
(d) développement de l'image selon un motif dans ces zones irradiées (14) et ayant réagi (16) par traitement avec un plasma à oxygène.

6. Procédé suivant la revendication 1, dans lequel cette couche de matériau polymère (12) a une épaisseur de l'ordre d'environ 0,5 à 20 µm.

7. Procédé suivant la revendication 6, dans lequel cette couche de matériau polymère (12) a une épaisseur de l'ordre d'environ 1,0 à 3,0 µm.

8. Procédé suivant la revendication 1, dans lequel cette partie supérieure irradiée de ces zones irradiées selon un motif de cette couche de matériau polymère a une profondeur de l'ordre d'environ 0,1 à 1,0 µm.

9. Procédé suivant la revendication 8, dans lequel cette partie supérieure irradiée de ces zones irradiées selon un motif de cette couche de matériau polymère a une profondeur de l'ordre d'environ 0,1 à 0,5 µm.

10. Procédé suivant la revendication 8, dans lequel ce réarrangement moléculaire de ce composant au moins présent s'étend principalement à l'intérieur de cette partie supérieure de cette couche de matériau polymère.

11. Procédé suivant la revendication 8, dans lequel ce réactif organométallique réactif comprend un composé contenant du silicium.

12. Procédé suivant la revendication 1, dans lequel ce substrat (10) comprend un matériau polymère qui est soit sensible à une irradiation, soit insensible à une irradiation.

13. Procédé suivant la revendication 1, dans lequel ce substrat (10) comprend un matériau inorganique.

**Patentansprüche**

1. Verfahren zum Überführen des oberen Teils (16) einer Schicht polymeren Materials (12) in eine trockenätzbeständige Form, das folgende Verfahrensschritte umfaßt:

a) Aufbringen einer Schicht polymeren Materials (12) auf ein Substrat (10), wobei das Substrat mindestens eine Verbindung enthält, bei der bei Bestrahlung eine molekulare Umlagerung erfolgt, so daß labiler und reaktiver Wasserstoff freigesetzt wird und die aus der folgenden Gruppe von Verbindungen ausgewählt wird: (1) o-Nitrobenzyl-Derivate, die sich bei Bestrahlung in Alkohole, Säuren und Amine umlagern, (2) Gruppen, in denen eine photochemische Fries-Umlagerung erfolgen kann und (3) Mischungen beider;
b) Musterförmige Bestrahlung von Teilen der Oberfläche (14) des polymeren Materials, um eine molekulare Umlagerung der Verbindung und die Freisetzung von labilem und reaktivem Wasserstoff zumindest in dem oberen Teil (16) der musterförmig bestrahlten Schicht zu erzielen; und
c) Behandlung der Reaktionsprodukte in der bestrahlten Schicht mit einer reaktiven organometallischen Verbindung, um die organometallische Verbindung mit den reaktiven Zentren im oberen Teil

(16) der Schicht polymeren Materials reagieren und eine Verbindung eingehen zu lassen, wobei die obere Schicht trockenätzbeständig wird.

2. Verfahren nach Anspruch 1, wobei die in dem polymeren Material enthaltene Verbindung aus der folgenden Gruppe von Verbindungen ausgewählt ist:

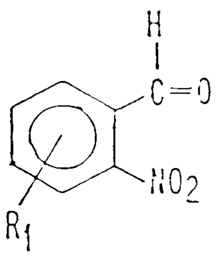 , 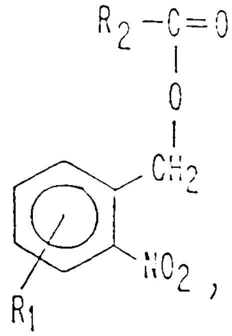 , 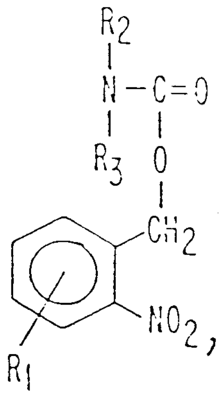 ,

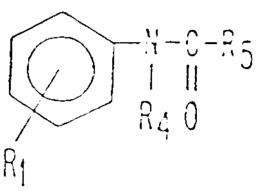 , 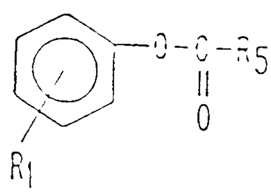 und 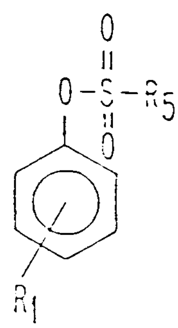

wobei $R_1$, $R_2$, $R_3$ und $R_5$ = H, Alkyl, Aryl oder Teil einer Polymerhauptkette und $R_4$ = H, $C_nH_{2n+1}$ wobei n etwa von 1 bis 5 läuft, Phenyl oder substituierte Phenyle.

3. Verfahren nach Anspruch 2, wobei $R_1$ Teil einer polymeren Hauptkette ist, die ein Styrolderivat oder ein Polymer auf Akrylatbasis ist, $R_2$, $R_3$, $R_5$ = H, $C_nH_{2n+1}$ wobei n von 1 bis etwa 15 läuft, Phenyl, substituierte Phenyle, und andere Radikale, die Benzolderivate sind, und $R_4$ = H, $C_nH_{2n+1}$ wobei n von 1 bis etwa 5 läuft, Phenyl und substituierte Phenyle.

4. Verfahren nach Anspruch 1, wobei die Strahlenquelle aus der folgenden Gruppe ausgewählt wird: Photonemissionsquellen, Elektronenstrahl, Ionenstrahl- und Röntgenstrahlquellen.

5. Verfahren nach Anspruch 1, wobei ein weiterer Verfahrensschritt vorliegt:

a) Entwicklung des musterförmigen Bildes auf den bestrahlten (14) und reagierten (16) Gebieten durch Behandlung mit einem Sauerstoffplasma.

6. Verfahren nach Anspruch 1, wobei die Dicke der Schicht aus polymerem Material zwischen etwa 0.5 und etwa 20 µm beträgt.

7. Verfahren nach Anspruch 6, wobei die Dicke der Schicht aus polymerem Material zwischen etwa 1.0 und etwa 3.0 µm beträgt.

8. Verfahren nach Anspruch 1, wobei die Dicke des durchstrahlten oberen Teils der musterförmig bestrahlten Gebiete der Schicht aus polymerem Material zwischen etwa 0.1 und etwa 1 µm beträgt.

**9.** Verfahren nach Anspruch 8, wobei die Dicke des durchstrahlten oberen Teils der musterförmig bestrahlten Gebiete der Schicht aus polymerem Material zwischen etwa 0.1 und etwa 0.5 µm beträgt.

**10.** Verfahren nach Anspruch 8, wobei die molekulare Umlagerung der zumindest einen Verbindung weitgehend in dem oberen Teil der Schicht aus polymerem Material stattfindet.

**11.** Verfahren nach Anspruch 8, wobei die reaktive organometallische Verbindung eine siliziumhaltige Verbindung ist.

**12.** Verfahren nach Anspruch 1, wobei das Substrat (10) ein polymeres Material enthält, das entweder strahlungsempfindlich oder nicht strahlungsempfindlich ist.

**13.** Verfahren nach Anspruch 1, wobei das Substrat (10) ein anorganisches Material enthält.

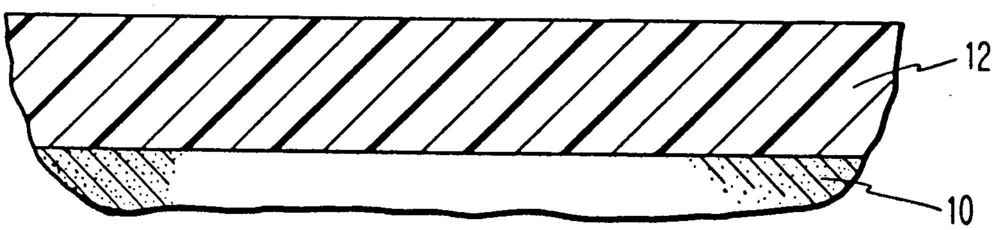


FIG. 1

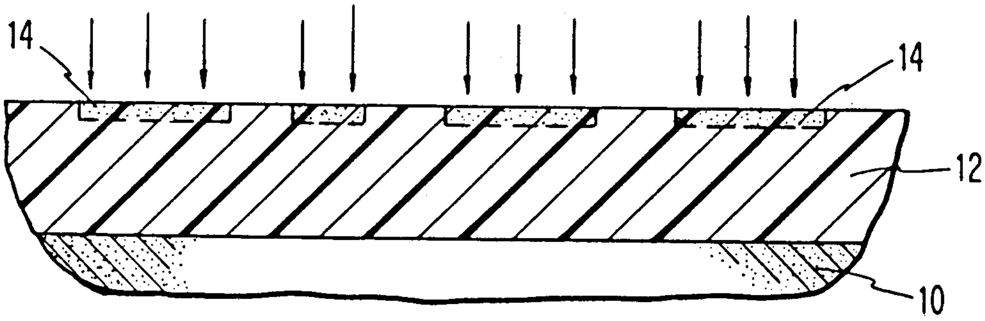


FIG. 2

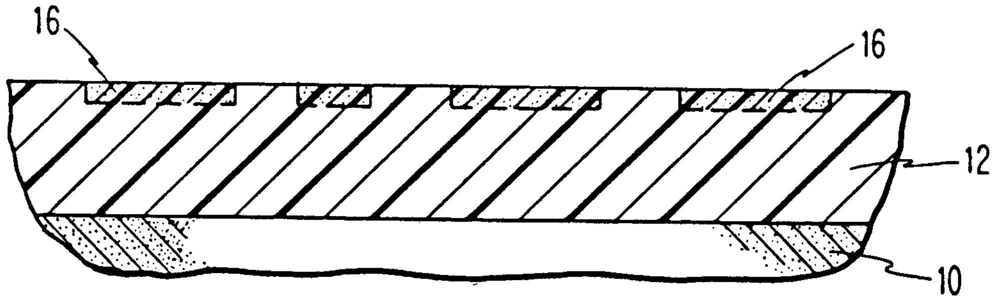


FIG. 3

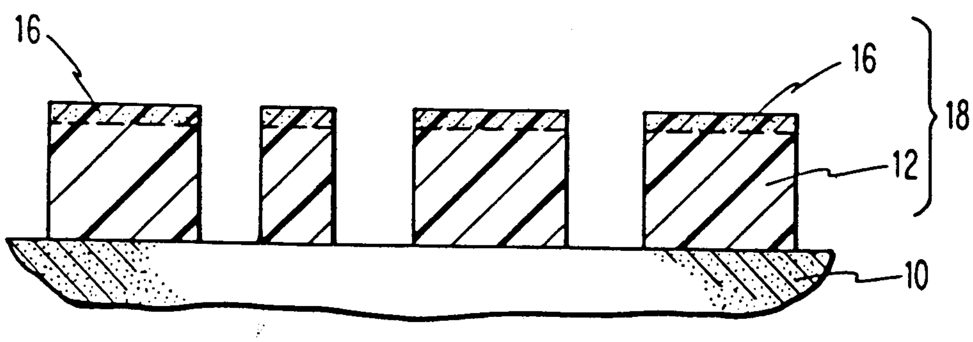


FIG. 4